# EUROPEAN PATENT SPECIFICATION

(11) **EP 2 871 775 B1**
(45) Date of publication and mention of the grant of the patent: **09.01.2019**
(21) Application number: 14192353.2
(22) Date of filing: 07.11.2014
(51) Int. Cl.: H03K 17/06, H03K 17/10, H03K 17/14, H03K 17/693, H01L 29/417, H01L 29/423, H01L 27/02, H04B 1/44

(54) **Devices and methods related to radio-frequency switches having improved performance**
Vorrichtungen und Verfahren in Zusammenhang mit Hochfrequenzschaltern mit verbesserter Leistung
Dispositifs et procédés relatifs à des commutateurs radiofréquences présentant des performances améliorées

(30) Priority: 12.11.2013 US 201361902808 P; 12.11.2013 US 201361902809 P; 12.11.2013 US 201361902810 P; 05.11.2014 US 201414534146; 05.11.2014 US 201414534148; 05.11.2014 US 201414534149
(43) Date of publication of application: 13.05.2015
(73) Proprietor: Skyworks Solutions, Inc., Woburn, MA 01801 (US)
(72) Inventor: Blin,Guillaume Alexandre, Carlisle, MA 01741 (US); Joshi, Aniruddha B., Irvine, CA 92603 (US); Masse, Christophe, Andover. MA 01810 (US)
(74) Representative: Lloyd, Patrick Alexander Desmond

(56) References cited:
- EP-A2- 0 766 396
- US-A1- 2005 014 473
- US-A1- 2005 270 083
- US-A1- 2008 174 357

## Description

The present disclosure generally relates to improved radio-frequency switching devices.

### Description of the Related Art

In some radio-frequency (RF) applications, switches are commonly arranged in a stack configuration to facilitate appropriate handling of power. For example, a higher stack height can be utilized to allow an RF switch to withstand higher power. An example of a RF switch arranged in a stack configuration is disclosed in US 2005/0270083.

### SUMMARY

The invention is defined by the independent claims, to which reference should be made.

For purposes of summarizing the disclosure, certain aspects, advantages and novel features of the inventions have been described herein. It is to be understood that not necessarily all such advantages may be achieved in accordance with any particular embodiment of the invention. Thus, the invention may be embodied or carried out in a manner that achieves or optimizes one advantage or group of advantages as taught herein without necessarily achieving other advantages as may be taught or suggested herein.

### Brief Description of the Drawings

Figure 1 shows a radio-frequency (RF) switch having a tuned stack.
Figure 2 shows that in some embodiments, switching transistors such as FETs for the stack of Figure 1 can be implemented in a finger configuration.
Figure 3 shows an example side sectional view of a portion indicated in Figure 2.
Figure 4 depicts a stack having a plurality of individual FETs.
Figure 5A shows that in some embodiments, a stack of FETs can be implemented with the FETs having a non-uniform distribution of a FET parameter, and where a first parameter distribution can generally track a second parameter distribution.
Figure 5B shows an example where the first parameter distribution has a relationship with the second parameter distribution, where the relationship is different than the scaled tracking relationship in the example of Figure 5A.
Figure 6 shows that in some embodiments, the first parameter distribution can include a plurality of groups of values, where FETs in each group have a common parameter value.
Figure 7 shows an example stack having 35 FETs in which varying values of, for example, gate width can be implemented so as to reduce voltage division imbalance within the stack.
Figure 8 shows a circuit representation of the example stack of Figure 7.
Figure 9 shows an example distribution of voltage values across the FETs of a stack having a fixed Lg value.
Figure 10 shows am example where the voltage distribution of Figure 9 can be adjusted to yield a scaled distribution by implementation of a non-uniform Lg distribution.
Figure 11 shows a process that can be implemented to configure a stack having one or more features as described herein.
Figure 12 shows a process that can be implemented to fabricate a stack having one or more features described herein.
Figure 13 shows an example of an RF switch having a stack of a plurality of FETs.
Figure 14 shows an example RF switch where dimension variation of the FETs can be implemented as, for example, different gate lengths.
Figure 15 depicts an RF switch configured to switch one or more signals between one or more poles and one or more throws.
Figure 16 shows that in some embodiments, the RF switch of Figure 15 can include an RF core and an energy management (EM) core.
Figure 17 shows a more detailed example configuration of the RF core of Figure 16, implemented in an example SPDT (single-pole double-throw) configuration.
Figure 18 shows an example where the SPDT configuration of Figure 17 is implemented with a stack of FETs for each of a series arm and a shunt arm associated with each of the two throws.
Figure 19 shows that FETs having one or more features as described herein can be controlled by a circuit configured to provide bias and/or coupling functionality.
Figure 20 shows examples of how biasing and/or coupling of different parts of one or more FETs can be implemented.
Figures 21A and 21B show plan and side sectional views of an example finger-based FET device implemented on silicon-on-insulator (SOI).
Figures 22A and 22B show plan and side sectional views of an example multiple-finger FET device implemented on SOI.
Figures 23A-23D show non-limiting examples of how one or more features of the present disclosure can be implemented on one or more semiconductor die.
Figures 24A and 24B show that one or more die having one or more features described herein can be implemented in a packaged module.
Figure 25 shows a schematic diagram of an example switching configuration that can be implemented in a module such as the example of Figures 24A and 24B.
Figure 26 depicts an example wireless device having one or more advantageous features described herein.

### Detailed Description of SOME Embodiments

The headings provided herein, if any, are for convenience only and do not necessarily affect the scope or meaning of the claimed invention.

In antenna tuning or some other radio-frequency (RF) switching applications, a plurality of switching elements (e.g., field-effect transistors (FET)) can be used as passive components. They are commonly arranged in a stack configuration to facilitate appropriate handling of power. For example, a higher FET stack height can be utilized to allow an RF switch to withstand high power under mismatch.

In some applications, RF switches can be subjected to high peak RF voltages that are much higher than the voltage handling capability of a single FET. For example, RF switches handling GSM power commonly need to be designed to handle 25Vpk while using FETs, with an individual handling voltage of, for example, 1.5V for 0.18µm on silicon-on-insulator (SOI) device, and 5Vpk for a gallium arsenide (GaAs) pseudomorphic high-electron-mobility transistor (pHEMT) device.

FET stacking configurations are commonly utilized (e.g., stack of individual FETs, multi-gate devices, or some combination thereof) to increase the voltage handling capability. In an ideal environment, the total voltage handling of a stack of such FETs should be equal to the sum of the individual handling voltages. However, parasitic effects (e.g., capacitive and/or resistive) relative to ground, between FETs of the stack, and/or respect to any other node associated with the stack circuit (such as a bias circuitry) can reduce the effective voltage handling capability by shunting some energy away from the stack of FETs.

For example, applications with higher voltage handling designs such as on-antenna tuning (e.g., aperture tuning), impedance matching, or higher power applications associated with base-stations, peak voltages can be as high as, for example, 100V to 200V. These designs typically utilize the stacking of a much higher number of devices, and the parasitic effects can become predominant, thereby limiting the maximum achievable voltage handling capability.

In the context of the foregoing higher voltage applications, more FETs can be arranged in series to meet the voltage handling requirements when the FETs are in an OFF state. Such an increase in the number of FETs may not be ideal in some situations. For example, degradation in ON-resistance (Ron) performance can occur when the FETs are in an ON state. It is noted that the total ON-resistance (Ron_total) of the stack is approximately equal to the stack height (stack_height) times the ON-resistance of a single FET (Ron_single_FET), assuming that all FETs have the same value of Ron_single_FET. For the voltage handling capability, the total voltage handling capacity (Vhandling) of the stack is typically much less than the product of the stack height (stack_height) and the voltage handling capacity of a single FET (Vhandling_single_FET). Thus, in some situations, Ron can degrade faster than the voltage handling improvement.

In the foregoing higher voltage applications where higher numbers of FETs are utilized, some FETs can be subjected to more voltages across them than necessary; and such devices can be further optimized in term of linearity (e.g., harmonics and intermodulation (e.g., IMD2, IMD3, IMD5, IP2, IP3)).

As described herein, one or more features of the present disclosure can provide, among others, improvements in the voltage handling capability of a given stack. In some embodiments, one or more of such advantageous features can be implemented in a simple stack of FETs, or a stack that utilizes other techniques for voltage imbalance compensation. In some embodiments, one or more of such advantageous features can also be implemented to yield or along with linearity improvement, and/or other biasing configurations for improving RF characteristics. Examples associated with such improvements in voltage handling performance are described herein in greater detail.

Also as described herein, one or more features of the present disclosure can allow reduction of the total Ron while maintaining the same or desirable voltage handling capability of the stack. In some embodiments, one or more of such advantageous features can be implemented in a simple stack of FETs, or a stack utilizes other techniques for voltage imbalance compensation. In some embodiments, one or more of such advantageous features can also be implemented to yield or along with linearity improvement, and/or other biasing configurations for improving RF characteristics. Examples associated with such improvements in Ron performance are described herein in greater detail.

As also described herein, one or more features of the present disclosure can allow further improvement in the linearity performance of the OFF stack by, for example, using more linear devices (e.g., typically shorter gate length) in parts of the stack where they can safely be used when in the OFF state. In some situations, the use of shorter gate length to improve linearity of the OFF stack can also improve the linearity of the ON stack by reducing the stack's overall Ron. For example, if the value of Ron increases in an RF system, the voltage developing across the ON stack can increase along with the harmonics and other linearity-degrading effects. A more compact area resulting from the use of a shorter gate length can reduce the coupling of the FET with the substrate and thus reduce non-linearity effects induced by the substrate. Further, such a reduction in area can allow use of a smaller die, thereby providing benefits associated with reduced cost and die size without sacrificing RF performance. Examples associated with such selective use of gate lengths to achieve further improvements in linearity performance are described herein in greater detail.

Described herein are devices and methods that can be implemented to address, among others, some or all of the foregoing examples of challenges and solutions associated with FET stacks. Although described in the context of FET stacks, it will be understood that one or more features of the present disclosure can also be implemented in switching stacks that utilize other types of switching elements. For example, switching or other type of stacks having diodes or microelectromechanical systems (MEMS) devices (e.g., MEMS capacitors or MEMS switches) as elements can also benefit from implementation of one or more features as described herein.

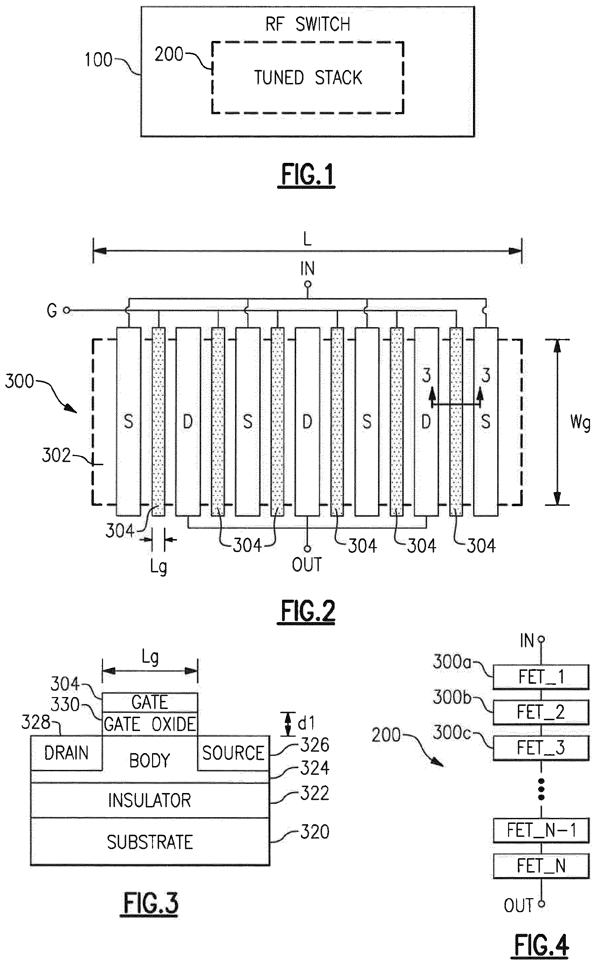

Figure 1 schematically shows an RF switch 100 having a tuned stack 200. In some embodiments, such a tuned stack can be implemented by some or all of the FETs in the stack having different values of a parameter selected to achieve a desired functionality for the stack. Such a desired functionality can include some or all of the three examples described herein -- improved voltage handling capability of a given stack, improved Ron performance, and improved linearity performance.

In some embodiments, the foregoing parameter having different values in a stack can include, for example, a dimension or a physical property associated with a part of a FET. In some embodiments, such a part associated with the FET can include a part that is inherent to the FET itself. In such embodiments, one can see that advantageous features provided by such tuning based on inherent part(s) of the FETs can be beneficial, since additional external components are not necessarily needed.

For the purpose of description, it will be understood that FETs can include, for example, metal-oxide-semiconductor FETs (MOSFETs) such as SOI MOSFETs. It will also be understood that FETs as described herein can be implemented in a number of process technologies, including but not limited to HEMT, SOI, silicon-on-sapphire (SOS), and CMOS technologies.

Figure 2 shows that in some embodiments, a FET 300 for a stack can be implemented in a finger configuration. Although various examples are described herein in the context of such a finger configuration, other FET configurations can also be implemented and benefit from one or more features of the present disclosure.

In the example, the FET 300 is shown to include an active region 302 having a dimension of length L and width Wg. Although described in the example context of a rectangular shape, it will be understood that other shapes of active region are also possible.

A plurality of source (S) and drain (D) contacts are shown to be implemented in a finger configuration, with gate fingers (304, with gate length Lg) interleaved therebetween. In some embodiments, each of the source and drain contacts (S, D) can form an ohmic metal contact with the active region 302, and each of the gate fingers 304 can include a metal contact coupled with the active region 302 through a gate oxide layer. Each of the source contacts S can be electrically connected to a first input node In, and each of the drain contacts D can be electrically connected to a first output node Out. It will be understood that each of S and D can be either an input or output, depending on a given layout. Each of the gates 304 can be electrically connected to a gate node G. Operation of such an FET as a switch element (e.g., by turning it ON or OFF by application of appropriate gate signals) can be implemented in known manners.

In some embodiments, one or more of the example FET parameters such as the active region length (e.g., L), gate width (e.g., Wg), gate length (e.g., Lg) can be different among at least some of the FETs in a stack. In the context of the active region length L, variation in such a FET parameter can be implemented by or facilitate, for example, different numbers of source-gate-drain units, length dimension (horizontal in the example depicted in Figure 2) of the source, drain and/or gate fingers, or any combination thereof.

Figure 3 shows an example side sectional view of a portion indicated in Figure 2. The example in Figure 3 shows an SOI configuration; however, it will be understood that one or more features of the present disclosure can also be implemented in other types of switching transistors.

In some embodiment, a source-gate-drain unit can include an insulator 322 formed over a substrate 320. A body 324 is shown to be formed over the insulator 322, and source/drain regions 326, 328 are shown to be formed on the body 324. The source/drain regions 326, 328 are shown to be separated by a portion of the body 324 below a gate 304 having a length dimension Lg. A gate oxide layer 330, having a thickness dimension d1, is shown to be provided between the gate 304 and the body 324.

In some embodiments, the gate length Lg, the gate oxide layer thickness d1, profiles of any doped areas in the FET, or any combination thereof, can be adjusted so as to yield a stack having at least some difference(s) in such parameter(s) among the FETs. The doped areas can include, for example, the source/drain regions 326, 328, the body 324, a halo region (not shown in Figure 3), or any other doped area.

Figure 4 schematically depicts a stack 200 having a plurality of individual FETs 300. N such FETs are shown to be connected in series between an input node (IN) and an output node (OUT), with the quantity N being a positive integer greater than 1. It will be understood that the input and output can be reversed in some embodiments, such that the OUT node receives a signal and the IN node outputs the signal.

As described herein, some or all of the FETs 300 in the stack 200 can have one or more parameters that are different from the other FETs. Examples of FETs having such different parameter(s) are described herein in greater detail.

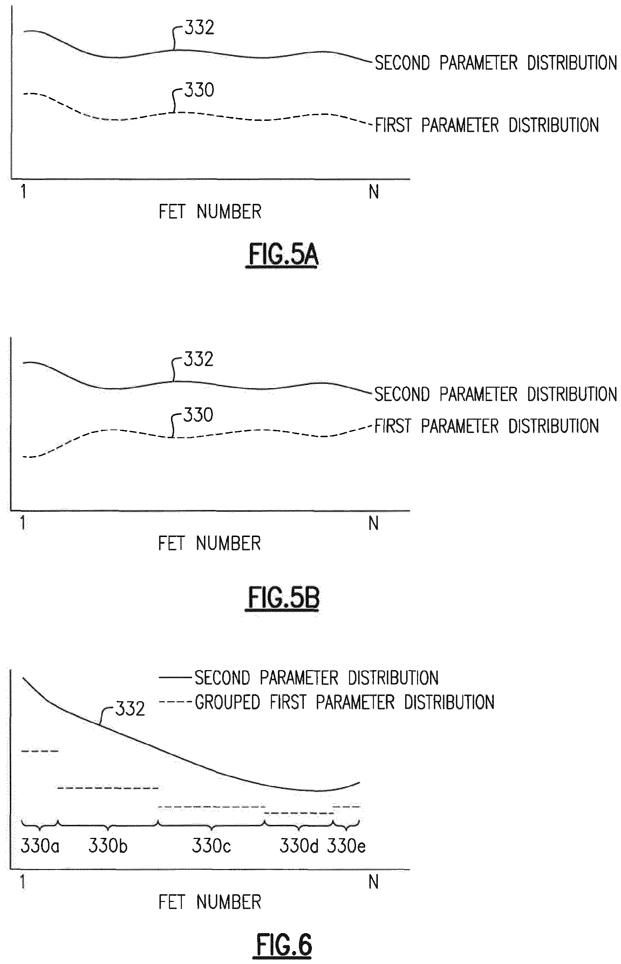

Figure 5A shows that in some embodiments, a stack of FETs, such as the example of Figure 4, can be implemented with the FETs having a non-uniform distribution 330 of a FET parameter. Such a non-uniform distribution can be based on a distribution 332 of another parameter associated with the FETs. In the example of Figure 5A, the non-uniform distribution 330 is referred to as a first parameter distribution; and the non-uniform distribution 332 is referred to as a second parameter distribution. Examples of such FET parameters associated with the first and second distributions 330, 332 are described herein in greater detail.

Figure 5A shows an example where the first parameter distribution 330 can generally track the second parameter distribution 332. In some embodiments, however, other types of relationships can be implemented. For example, Figure 5B shows an example where the first parameter distribution 330 has a relationship with the second parameter distribution 332, where the relationship is different than the scaled tracking relationship in the example of Figure 5A. Such a relationship can include, for example, a situation where the first parameter distribution 330 increases when the second parameter distribution 332 decreases, and vice versa. Other types of relationships are also possible. In each of the examples of Figures 5A and 5B, the first parameter distribution 330 that is implemented or is to be implemented in a stack, is depicted as a continuous function based on its respective second parameter distribution 332. For example, for a given FET number, the first parameter distribution 330 can have any value. However, it may not be desirable or practical to vary the parameter for every FET in such a continuous or fine manner.

Figure 6 shows that in some embodiments, the first parameter distribution can include a plurality of groups of values, where FETs in each group have a common parameter value. For example, a group (330a) of FETs is shown to have a common value for the FET parameter for a corresponding range of the second parameter distribution. Similarly, a group (330b) of FETs is shown to have a common value for the FET parameter for a corresponding range of the second parameter distribution. Overall, the trend of the grouped common values (330a-330e) can generally track the second parameter distribution 332. It will be understood that other types of relationships (such as the example of Figure 5B) can also be implemented with the foregoing grouping of FET parameter values.

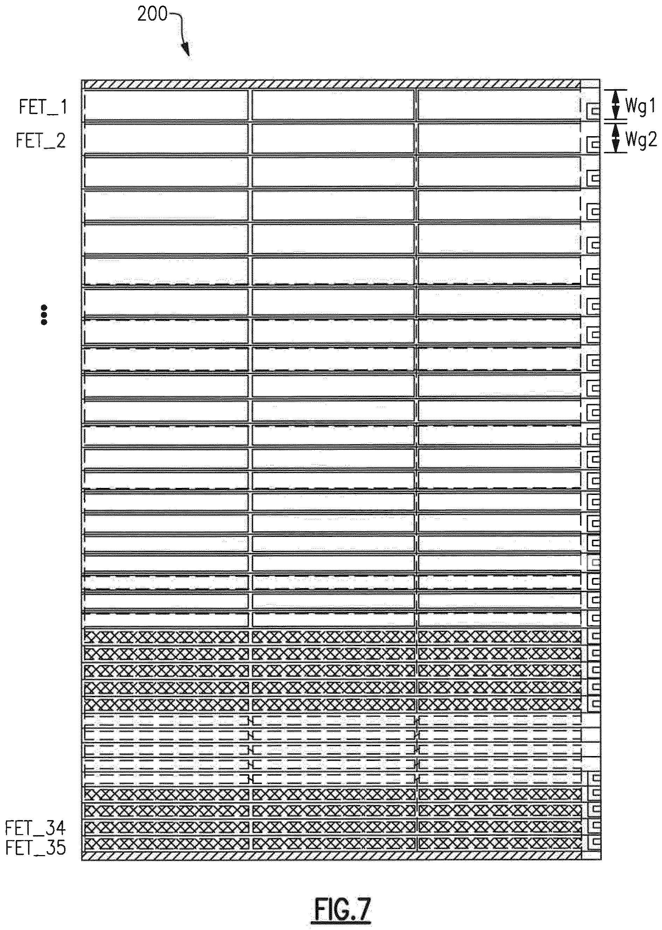

Figures 7-10 show examples of how a FET parameter such as a gate length Lg can be mapped for a stack of FETs, based on another FET parameter such as a voltage across a FET (VDS). In such examples, a distribution of Lg values can be the first parameter distribution described herein in reference to Figures 5 and 6; and a distribution of VDS values can be the second parameter distribution. The examples of Figures 7-10 also demonstrate how performance of the stack can be improved for different operating parameters based on such mapping of the first parameter (e.g., Lg values). In some implementations, such improvement(s) can be achieved without sacrificing performance in other operating parameter(s).

Figure 7 shows a stack 200 having 35 FETs (FET_1, FET_2, ..., FET_35). It will be understood that other numbers of FETs can be utilized. In the example, the FETs are shown to have varying values of gate width (Wg in Figure 2, Wg1, Wg2, etc. in Figure 7) so as to, for example, reduce voltage division imbalance within the stack 200. Additional details concerning such a technique can be found in U.S. Patent Application No. 14/451,321, entitled FIELD-EFFECT TRANSISTOR STACK VOLTAGE COMPENSATION.

For example, a stack having 10 FETs with respective gate widths Wg1 to Wg10 are listed in Table 1. Each of the 10 FETs in Table 1 has 100 gate fingers.

**Table 1**

| FET # | Gate width | Gate width value (□m) |
|---|---|---|
| 1 | Wg1 | 13.6 |
| 2 | Wg2 | 11.9 |
| 3 | Wg3 | 10.8 |
| 4 | Wg4 | 10.0 |
| 5 | Wg5 | 9.5 |
| 6 | Wg6 | 8.9 |
| 7 | Wg7 | 8.5 |
| 8 | Wg8 | 8.3 |
| 9 | Wg9 | 8.2 |
| 10 | Wg10 | 8.5 |

For such variable-dimension FETs, it is shown by simulated data that relative voltage drop at each of the FETs is much more uniform than a configuration of 10 FETs having a constant gate width (e.g., 10 µm).

For example, in the constant gate width configuration, there is a voltage drop of about 0.135 of an input voltage (e.g., 5V) across FET1, about 0.118 of the input voltage across FET2, and so on, with the voltage drop decreasing to about 0.087 of the input voltage across FET9 (and increasing slightly for FET10). For the variable dimension configuration of Table 1, there is a voltage drop of about 0.103 of the input voltage (e.g., 5V) across FET1, about 0.101 of the input voltage across each of FET2 to FET10. Thus, one can see that voltage imbalance can be reduced drastically by the variable dimension configuration of Table 1 so as to yield a generally even voltage distribution. In some embodiments, such a relatively even voltage distribution along the stack can result in improvement of switch performance with respect to, for example, harmonic peaking, compression point and/or intermodulation distortion (IMD).

It is further noted that in the foregoing even voltage distribution example, the highest value is approximately 0.103 of the input voltage (across the first FET). Accordingly, a breakdown voltage of the example stack of Table can be estimated by scaling the input voltage (e.g., 5V) with the weak link having the highest relative voltage drop (e.g., 0.103 for the first FET). One can see that such an estimate desirably yields a value of 5/0.103, or approximately 48V, which is very close to the estimate for an ideal configuration that does not have voltage imbalance.

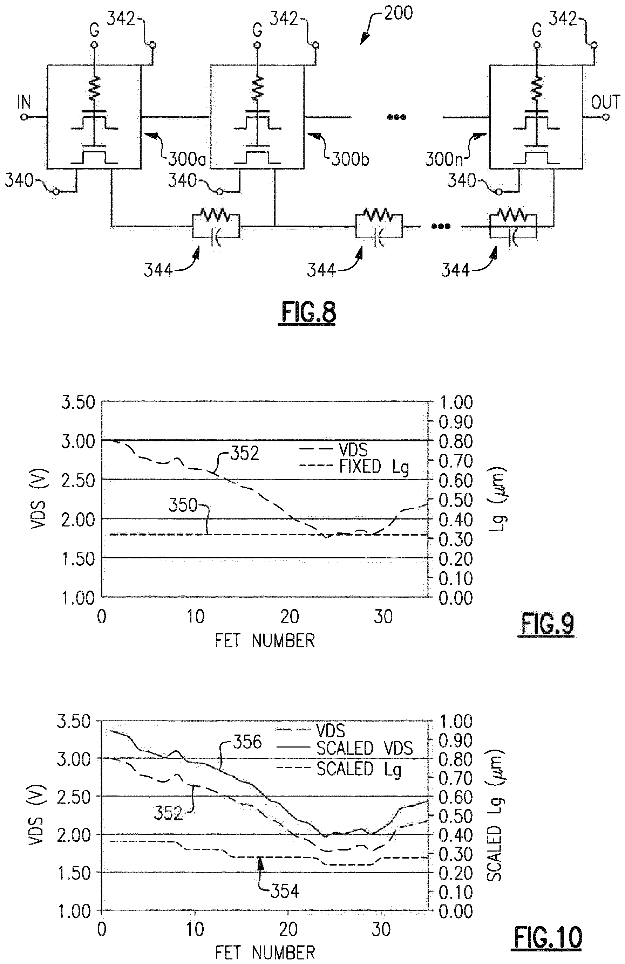

Figure 8 shows a circuit representation of the example stack 200 of Figure 7. As shown, 35 FETs (300a, 300b, ..., 300n) can be connected in series, with the first FET 300a being in communication with an input node (IN), and the last FET 300n being in communication with an output node (OUT). As described herein the stack 200 can be operated in reverse in some implementations, such that the input signal is provided at the OUT terminal and the output signal is provided at the IN terminal.

In the example circuit of Figure 8, each FET is depicted as having a plurality of gate fingers in communication with a gate signal node G through a gate resistance. Such gate nodes can be controlled together for all of the FETs, individually, or some combination thereof.

In the example circuit, nodes 342 (e.g., 304 in Figure 3) are the same as the gate nodes G, and a body node for each FET is indicated as 340. Further, parallel-RC circuits 344 are shown to provide example substrate coupling.

For the example stack configuration of Figures 7 and 8, a simulation was performed with a fixed value of Lg (e.g., approximately 0.32 µm) for all of the 35 FETs. Voltage values across the respective FETs observed in such a simulation are listed in Table 2, under the VDS column. The same VDS values are plotted in Figure 9 (curve 352), along with the fixed Lg value (line 350).

**Table 2**

| FET Number | VDS (V) | Fixed Lg (□m) |
|---|---|---|
| 1 | 3.00 | 0.32 |
| 2 | 2.96 | 0.32 |
| 3 | 2.92 | 0.32 |
| 4 | 2.78 | 0.32 |
| 5 | 2.76 | 0.32 |
| 6 | 2.71 | 0.32 |
| 7 | 2.70 | 0.32 |
| 8 | 2.77 | 0.32 |
| 9 | 2.65 | 0.32 |
| 10 | 2.63 | 0.32 |
| 11 | 2.62 | 0.32 |
| 12 | 2.57 | 0.32 |
| 13 | 2.51 | 0.32 |
| 14 | 2.47 | 0.32 |
| 15 | 2.40 | 0.32 |
| 16 | 2.38 | 0.32 |
| 17 | 2.29 | 0.32 |
| 18 | 2.19 | 0.32 |
| 19 | 2.15 | 0.32 |
| 20 | 2.04 | 0.32 |
| 21 | 1.96 | 0.32 |
| 22 | 1.93 | 0.32 |
| 23 | 1.85 | 0.32 |
| 24 | 1.76 | 0.32 |
| 25 | 1.80 | 0.32 |
| 26 | 1.79 | 0.32 |
| 27 | 1.82 | 0.32 |
| 28 | 1.85 | 0.32 |
| 29 | 1.79 | 0.32 |
| 30 | 1.86 | 0.32 |
| 31 | 1.93 | 0.32 |
| 32 | 2.08 | 0.32 |
| 33 | 2.12 | 0.32 |
| 34 | 2.14 | 0.32 |
| 35 | 2.18 | 0.32 |

In some implementations, a larger gate length Lg typically yields a higher breakdown voltage (BVdss). In some situations, higher values of BVdss are desirable; however, there is typically a limit on how much Lg can be increased without significantly degrading other performance parameter(s) of the FET.

In the example of Figure 9 and Table 1, the highest VDS value is associated with the first FET, at approximately 3.00V, which is preferably below the breakdown voltage BVdss for that FET. Near the other end, the lowest VDS value is approximately 1.76V for FET 24. Thus, a constant gate length value Lg (e.g., 0.32 µm) for all of the FETs having such a range of VDS values is not an efficient implementation of a gate dimension such as Lg. For example, a FET may be able have a larger Lg value than the constant value (e.g., 0.32 µm) so as to increase BVdss without significantly degrading performance. In another example, a FET may be able to have a lower Lg value than the constant value (e.g., 0.32 µm) because BVdss may not need to be as high.

In some embodiments, a FET stack such as the examples described herein can be tuned for a more efficient implementation of a FET parameter such as gate length Lg. With such a tuned configuration, the stack as a whole can benefit significantly. Examples associated with such tuning and benefits that can be realized are described herein in greater detail.

In some implementations, the foregoing tuning technique can include identification of a distribution of VDS across a stack. Such a distribution can be obtained by, for example, simulation and/or measurement. The VDS curve 352 in Figure 9 is an example of such a distribution.

Based on some configuration (e.g., type and/or process technology) associated with the FETs of the stack, the highest VDS value (e.g., the first FET) of the foregoing VDS-distribution can be scaled up to a higher value that is still below the breakdown voltage BVdss with an increased gate length Lg that is still acceptable (e.g., in terms of its effects on other FET performance parameters). With such a scaled VDS value, the VDS-distribution can be scaled up accordingly. For example, the VDS-distribution (e.g., curve 352 in Figure 9) can be scaled up by approximately 12%.

Figure 10 shows the same un-scaled VDS curve 352 of Figure 9, as well as a scaled VDS curve 356 that is approximately 1.12 times the curve 352. Values associated with the un-scaled VDS curve 352 and the scaled VDS curve 356 are listed in Table 3 under columns indicated as "VDS" and "Scaled VDS." In some embodiments, and as shown by example in Figure 10 and Table 3, the scaled VDS values for a given Lg value can remain at or below a maximum or selected VDS value.

For example, FETs 1-8 having Lg of 0.36 µm are shown to have scaled VDS values that are less than or equal to a corresponding selected VDS value of 3.5V. Similarly, FETs 9-13 having Lg of 0.32 µm are shown to have scaled VDS values that are less than or equal to a corresponding selected VDS value of 3.0V; FETs 14-23 having Lg of 0.28 µm are shown to have scaled VDS values that are less than or equal to a corresponding selected VDS value of 2.8V; FETs 24-29 having Lg of 0.24 µm are shown to have scaled VDS values that are less than or equal to a corresponding selected VDS value of 2.0V; and FETs 30-35 having Lg of 0.28 µm are shown to have scaled VDS values that are less than or equal to a corresponding selected VDS value of 2.8V.

**Table 3**

| FET Number | VDS (V) | Scaled VDS (V) | Scaled Lg (µm) |
|---|---|---|---|
| 1 | 3.00 | 3.36 | 0.36 |
| 2 | 2.96 | 3.32 | 0.36 |
| 3 | 2.92 | 3.27 | 0.36 |
| 4 | 2.78 | 3.11 | 0.36 |
| 5 | 2.76 | 3.09 | 0.36 |
| 6 | 2.71 | 3.04 | 0.36 |
| 7 | 2.70 | 3.02 | 0.36 |
| 8 | 2.77 | 3.10 | 0.36 |
| 9 | 2.65 | 2.97 | 0.32 |
| 10 | 2.63 | 2.94 | 0.32 |
| 11 | 2.62 | 2.93 | 0.32 |
| 12 | 2.57 | 2.88 | 0.32 |
| 13 | 2.51 | 2.81 | 0.32 |
| 14 | 2.47 | 2.77 | 0.28 |
| 15 | 2.40 | 2.69 | 0.28 |
| 16 | 2.38 | 2.66 | 0.28 |
| 17 | 2.29 | 2.57 | 0.28 |
| 18 | 2.19 | 2.45 | 0.28 |
| 19 | 2.15 | 2.41 | 0.28 |
| 20 | 2.04 | 2.29 | 0.28 |
| 21 | 1.96 | 2.19 | 0.28 |
| 22 | 1.93 | 2.16 | 0.28 |
| 23 | 1.85 | 2.07 | 0.28 |
| 24 | 1.76 | 1.97 | 0.24 |
| 25 | 1.80 | 2.02 | 0.24 |
| 26 | 1.79 | 2.01 | 0.24 |
| 27 | 1.82 | 2.04 | 0.24 |
| 28 | 1.85 | 2.07 | 0.24 |
| 29 | 1.79 | 2.01 | 0.24 |
| 30 | 1.86 | 2.08 | 0.28 |
| 31 | 1.93 | 2.16 | 0.28 |
| 32 | 2.08 | 2.33 | 0.28 |
| 33 | 2.12 | 2.37 | 0.28 |
| 34 | 2.14 | 2.40 | 0.28 |
| 35 | 2.18 | 2.44 | 0.28 |

With the foregoing increased gate length Lg (e.g., 0.36 µm) corresponding to BVdss of the highest VDS FET (e.g., the first FET), a new Lg-distribution can be obtained. An example of such a new Lg-distribution is shown in Figure 10 as a distribution 354, and the corresponding values are listed in Table 3 under the column indicated as "Scaled Lg."

It is noted that the example Lg values in Figure 10 and Table 3 are grouped in five groups, similar to the example described herein in reference to Figure 6. It is also noted that the Lg values associated with the five groups generally follow the trend of the scaled VDS curve 356. Table 4 lists an example scheme that assigns different values for different ranges of the scaled VDS curve 356.

**Table 4**

| Range (V) | Lg (µm) |
|---|---|
| 3.0 ≤ VDS < 3.5 | 0.36 |
| 2.8 ≤ VDS < 3.0 | 0.32 |
| 2.0 ≤ VDS < 2.8 | 0.28 |
| VDS < 2.0 | 0.24 |

In some situations, the new Lg distribution obtained in the foregoing example manner may or may not alter the VDS distribution in a way that is sub-optimal or undesirable. If such a VDS distribution is sub-optimal or undesirable, one or more steps of the foregoing technique can be modified.

As described herein, a new Lg distribution obtained in the foregoing manner can yield a tuned stack of FETs. For example, Lg some values can be increased (e.g., 0.36 µm which is greater than the constant value of 0.32 µm) for FET(s) that need such higher values. On the other hand, some Lg values can be decreased (e.g., 0.24 µm which is less than the constant value of 0.32 µm) for FET(s) that do not need higher values. Such a tuned configuration can provide a number of performance improvements for the stack. Non-limiting examples of such performance improvements are described below.

### Improved Voltage Handling Capability

As described herein, one or more features of the present disclosure can improve the voltage handling capability of a stack of FETs. Voltage handling of a FET is typically specified in terms of a breakdown voltage (BVdss) at which point the leakage current increases and levels of harmonics increase sharply.

The example tuning configuration described herein in reference to the scaled VDS distribution 356 of Figure 10 has a total VDS value of approximately 90V (sum of the Scaled VDS values for the 35 FETs in Table 3), while the un-scaled VDS distribution 352 has a total VDS value of approximately 80V. Thus, the tuned configuration is shown to provide approximately an extra 10V of voltage handling capability for the stack.

The foregoing example improvement in voltage handling capability is described in the context of tuning the gate lengths of the various FETs in the stack. It will be understood that other FET parameters can also be tuned to achieve similar results. For example, breakdown voltage (BVdss) optimization or improvement can be achieved by doping profile and/or construction modification. Modification(s) can be made in doping of the source, drain, body, halo region and/or any other doped area to increase or decrease the BVdss. In some embodiments, such FET devices can be fabricated by further processing steps (e.g., extra masks) or use of different construction and/or layout.

In another example, use of thicker gate oxide layers (e.g., 330 in Figure 3) can yield higher breakdown voltage. However, such an increase in BVdss can result in degradation of other parameters such as Ron. Accordingly, tuning of a stack based on the gate oxide layer thickness can be achieved by balancing the conflicting performance parameters.

Although the various examples for the voltage handling improvement are described in the context of a stack of FETs, it will be understood that one or more features of the present disclosure can also be applied to other stacked devices. For example, in the context of a stack having micro-electro-mechanical systems (MEMS) devices such as MEMS-capacitors or MEMS-switches, parameters such as beam length, width, and/or thickness can be tuned to achieve improved voltage handling capability.

### Improved Ron Performance:

As described herein, one or more features of the present disclosure can improve the Ron performance of a stack of FETs. Typically, voltage handling capability and Ron vary in the same direction. Thus, in some embodiments, if a first FET does not need to withstand as much voltage as a second FET, the first FET can be configured with a Ron that is lower than the Ron of the second FET.

In some implementations, a design for a stack of FETs can include a feature of decreasing Ron while maintaining the voltage handling capability. For such a design, use of FETs with having desirable characteristics for both BVdss and Ron (e.g., lower BVdss and lower Ron) can be utilized. For example, if the initial design uses a 0.32 µm FET, a new FET with Lg < 0.32 µm can be utilized if that FET is not subjected to a higher voltage. As described herein in the context of the examples associated with Figures 7-10, Lg can be adjusted to tune the voltage handling capability of each FET or groups of FETs, thereby yielding a higher voltage handling capability for the stack as a whole. In such a design, it is noted that some Lg values may be higher than the Lg values in the original design, thereby increasing the Ron values for those FETs. However, because such a tuned configuration can include some FETs having lower Lg values, the stack overall can have a lower Ron value.

For example, in the Lg values listed in Tables 2 and 3, the sum of fixed Lg values in the original design (0.32 µm for each FET in Table 2) is approximately 11.2 µm. In Table 3, the sum of varying Lg values is approximately 10.4 µm. Thus, in such particular examples, both of the voltage handling capability and the Ron performance are improved, with the former increasing and the latter decreasing. If a design calls for an improved Ron performance with a lowered Ron value for a stack while maintaining the overall voltage handling capability, one can see that the stack's Ron value can be lowered even further, since the voltage handling capability does not need to increase.

The foregoing example improvement in Ron performance is described in the context of tuning the gate lengths of the various FETs in a stack. It will be understood that other FET parameters can also be tuned to achieve similar results. For example, Ron optimization or improvement can be achieved by doping profile and/or construction modification. Modification(s) can be made in doping of the source, drain, body, halo region and/or any other doped area to increase or decrease Ron. In some embodiments, such FET devices can be fabricated by further processing steps (e.g., extra masks) or use of different construction and/or layout.

In another example, use of thinner gate oxide layers (e.g., 330 in Figure 3) can yield lower Ron values. However, such a decrease in Ron can result in unwanted degradation of other parameters such as BVdss. Accordingly, tuning of a stack based on the gate oxide layer thickness can be achieved by balancing the conflicting performance parameters.

Although the various examples for the Ron performance improvement are described in the context of a stack of FETs, it will be understood that one or more features of the present disclosure can also be applied to other stacked devices. For example, in the context of a stack having micro-electro-mechanical systems (MEMS) devices such as MEMS-capacitors or MEMS-switches, parameters such as beam length, width, and/or thickness can be tuned to achieve improved Ron performance.

### Improved Linearity Performance:

In some implementations, one or more features of the present disclosure can be utilized to improve linearity performance of a stack of FETs, when the stack is ON and/or when the stack is OFF. When the stack is ON, improvement in linearity performance of the stack can be achieved by reducing the overall Ron of the stack. In some embodiments, such a reduction in the overall Ron can be implemented through a use of FETs having shorter gate lengths as described herein. Other techniques described herein under the section "Improved Ron Performance" can also be utilized to reduce the overall Ron. Such a reduction in the overall Ron can reduce the voltage developed across the ON stack, and thus reduce the harmonics or other non-linearity effects generated by the stack.

When the stack is OFF, improvement in linearity performance can be achieved by configuring some of the FETs in the stack to operate near breakdown (e.g., by using FETs having higher BVdss), and using higher linearity FETs that are operated well below their breakdown voltages for some or all of the other FETs in the stack.

When the stack is ON or OFF, improvement in linearity performance can be achieved by reducing the layout area of the stack. Such a reduction in layout area can reduce the coupling of the stack with the substrate, thereby reducing non-linearity effects that can be driven by the substrate. In some embodiments, such a reduction in layout area can be achieved by, for example, reducing the gate length Lg when appropriate as described herein, and/or reducing the gate width Wg when appropriate, also as described herein.

In some situations, the foregoing example improvement in linearity performance can be implemented by tuning the gate lengths of the various FETs in the stack. It will be understood that other FET parameters can also be tuned to achieve similar results. For example, linearity optimization or improvement can be achieved by doping profile and/or construction modification. Modification(s) can be made in doping of the source, drain, body, halo region and/or any other doped area to affect linearity. In some embodiments, such FET devices can be fabricated by further processing steps (e.g., extra masks) or use of different construction and/or layout.

In the context of improving linearity performance by reduction in Ron, use of thinner gate oxide layers (e.g., 330 in Figure 3) can yield lower Ron values. However, such a decrease in Ron can result in unwanted degradation of other parameters such as BVdss. Accordingly, tuning of a stack based on the gate oxide layer thickness can be achieved by balancing the conflicting performance parameters.

Although the various examples for the linearity performance improvement are described in the context of a stack of FETs, it will be understood that one or more features of the present disclosure can also be applied to other stacked devices. For example, in the context of a stack having micro-electro-mechanical systems (MEMS) devices such as MEMS-capacitors or MEMS-switches, parameters such as beam length, width, and/or thickness can be tuned to achieve improved linearity performance.

### Example Method of Configuring a Stack:

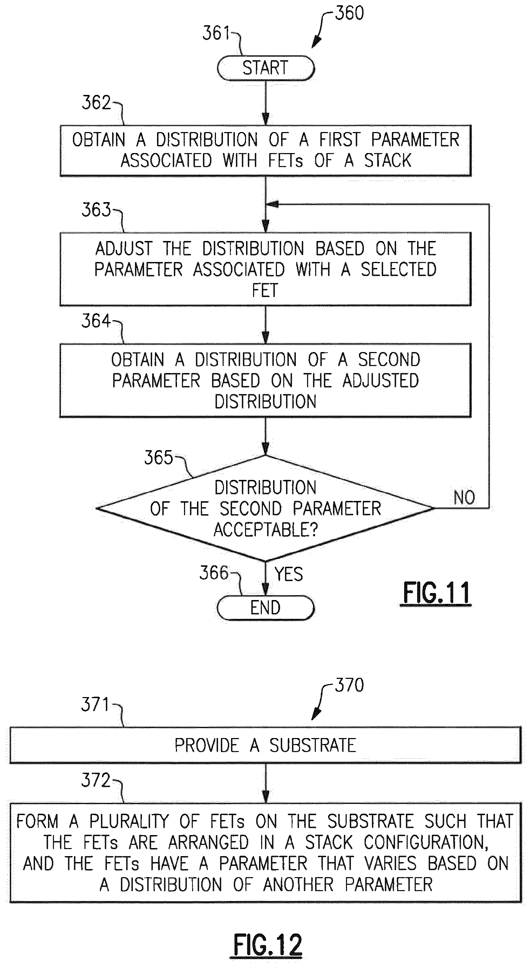

Figure 11 shows a process 360 that can be implemented to configure a stack having one or more features as described herein. The process 360 can begin at block 361; and in block 362, a distribution of a first parameter associated with FETs of a stack can be obtained. In block 363, the obtained distribution can be adjusted based on the parameter associated with a selected FET. For example, the first FET in a stack can have the highest voltage VDS, and the distribution can be adjusted based on such a VDS value. In block 364, a distribution of a second parameter can be obtained based on the adjusted distribution. In a decision block 365, the process 360 can determine whether the distribution of the second parameter is acceptable. If the answer is "Yes," the process 360 can end in block 366. If the answer is "No," the process 360 can perform steps 363 and 364 to generate another distribution of second parameter.

### Example Method of Fabricating a Stack:

Figure 12 shows a process 370 that can be implemented to fabricate a stack having one or more features described herein. In block 371, a substrate can be provided. In some embodiments, such a substrate can be an SOI substrate. In block 372, a plurality of FETs can be formed on the substrate such that the FETs are arranged in a stack configuration. The FETs can have a parameter that varies based on a distribution of another parameter.

### Examples of Switching Applications:

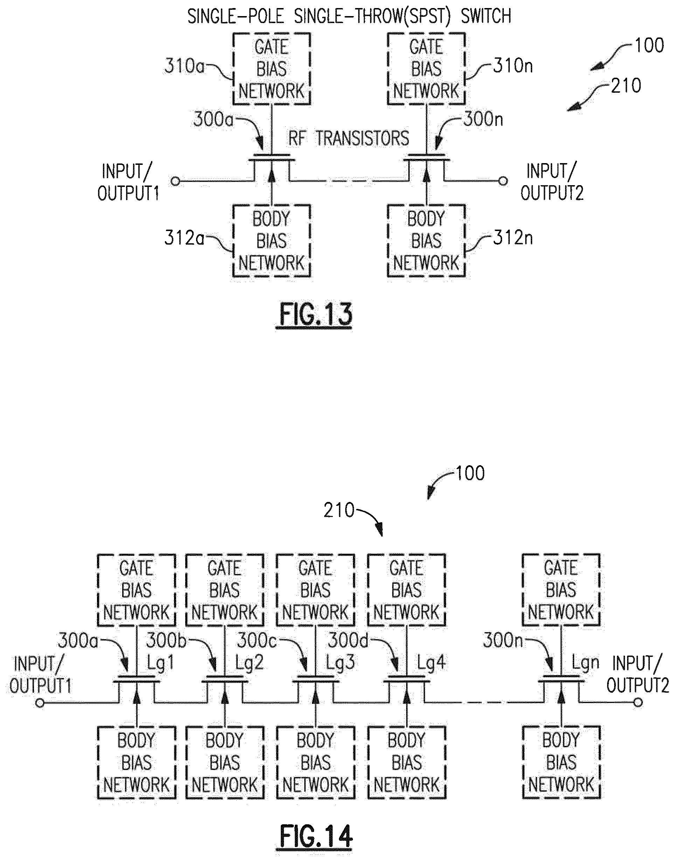

In some embodiments, a FET stack having two or more FETs can be implemented as an RF switch. Figure 13 shows an example of an RF switch having a stack 210 of a plurality of FETs (e.g., N of such FETs 300a to 300n). Such a switch can be configured as a single-pole-single-throw (SPST) switch. Although described in the context of such an example, it will be understood that one or more of stacks 210 can be implemented in other switch configurations.

In the example of Figure 13, each of the FETs (300a to 300n) can be controlled by its respective gate bias network 310 and body bias network 312. In some implementations, such control operations can be performed in known manners.

In some embodiments, an RF switch such as the example of Figure 13 can include FETs having one or more features described herein. Figure 14 shows an example RF switch 100 where such features can be implemented as different gate lengths. In the example, an FET stack 210 is shown to include FETs (300a-300n) with their respective gate lengths (Lg1-Lgn). Some or all of such gate lengths can be selected to be different so as to yield a desirable performance improvement for the RF switch 100.

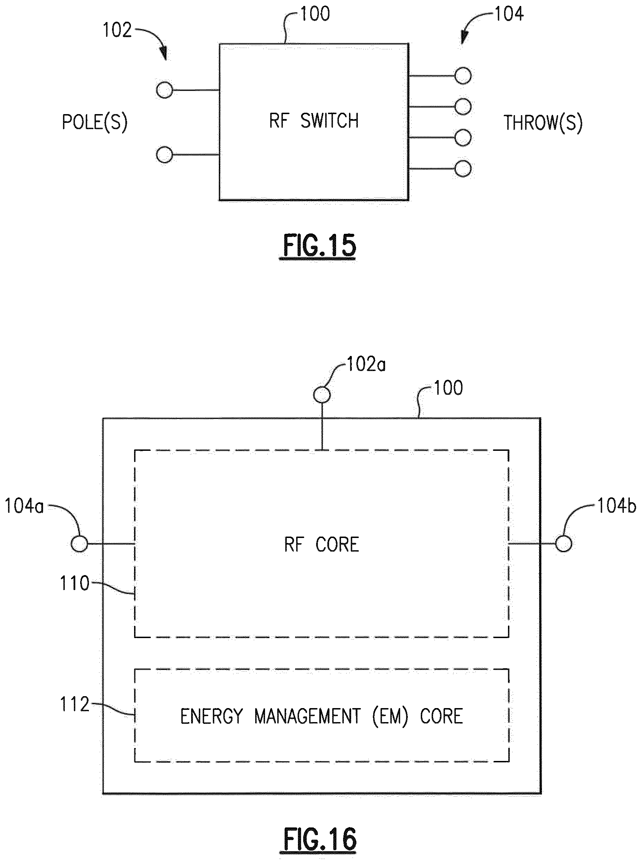

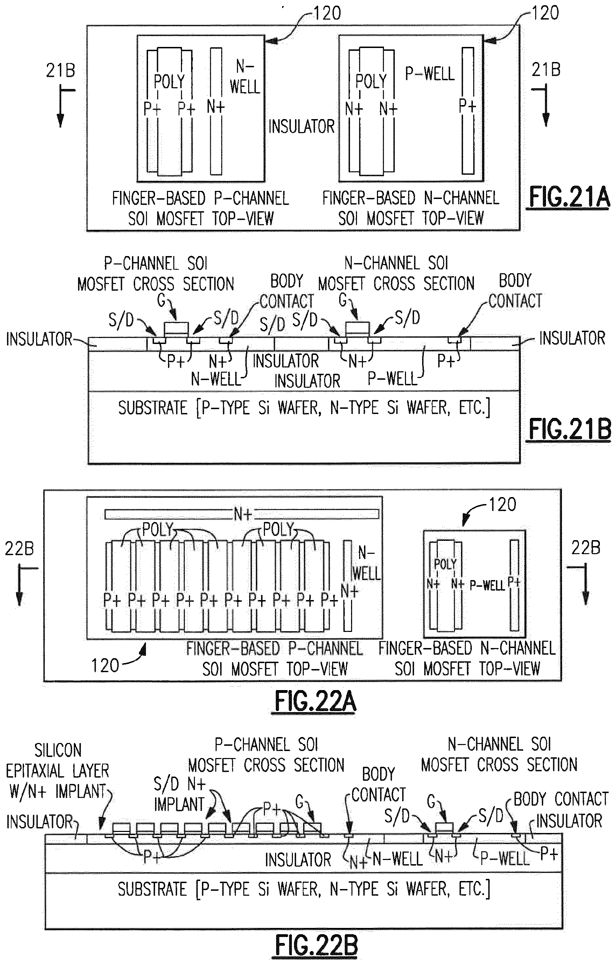

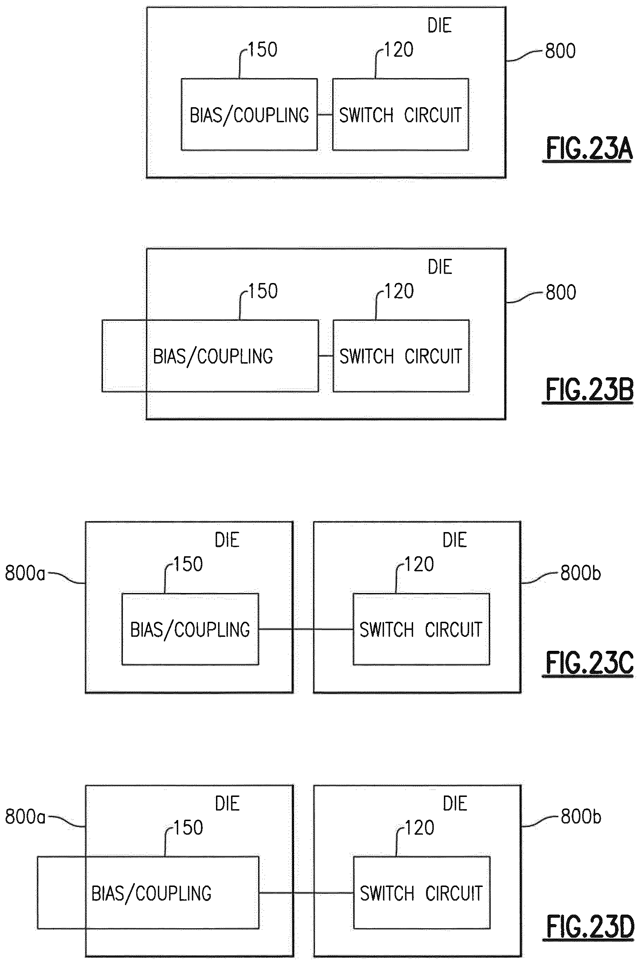

Figures 15-20 show non-limiting examples of switching applications where one or more features of the present disclosure can be implemented. Figures 21 and 22 show examples where one or more features of the present disclosure can be implemented in SOI devices. Figure 23-26 show examples of how one or more features of the present disclosure can be implemented in different products.

### Example Components of a Switching Device:

Figure 15 shows a radio-frequency (RF) switch 100 configured to switch one or more signals between one or more poles 102 and one or more throws 104. In some embodiments, such a switch can be based on one or more field-effect transistors (FETs) such as silicon-on-insulator (SOI) FETs. When a particular pole is connected to a particular throw, such a path is commonly referred to as being closed or in an ON state. When a given path between a pole and a throw is not connected, such a path is commonly referred to as being open or in an OFF state.

Figure 16 shows that in some implementations, the RF switch 100 of Figure 15 can include an RF core 110 and an energy management (EM) core 112. The RF core 110 can be configured to route RF signals between the first and second ports. In the example single-pole-double-throw (SPDT) configuration shown in Figure 16, such first and second ports can include a pole 102a and a first throw 104a, or the pole 102a and a second throw 104b.

In some embodiments, the EM core 112 can be configured to supply, for example, voltage control signals to the RF core. The EM core 112 can be further configured to provide the RF switch 100 with logic decoding and/or power supply conditioning capabilities.

In some embodiments, the RF core 110 can include one or more poles and one or more throws to enable passage of RF signals between one or more inputs and one or more outputs of the switch 100. For example, the RF core 110 can include a single-pole double-throw (SPDT or SP2T) configuration as shown in Figure 16.

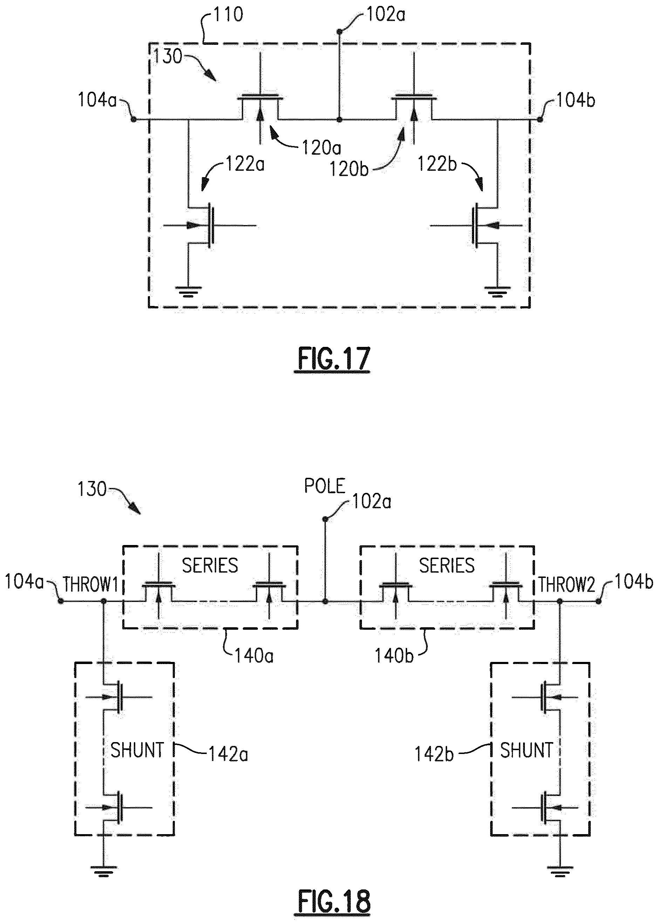

In the example SPDT context, Figure 17 shows a more detailed example configuration of an RF core 110. The RF core 110 is shown to include a single pole 102a coupled to first and second throw nodes 104a, 104b via first and second transistors (e.g., FETs) 120a, 120b. The first throw node 104a is shown to be coupled to an RF ground via an FET 122a to provide shunting capability for the node 104a. Similarly, the second throw node 104b is shown to be coupled to the RF ground via an FET 122b to provide shunting capability for the node 104b.

In an example operation, when the RF core 110 is in a state where an RF signal is being passed between the pole 102a and the first throw 104a, the FET 120a between the pole 102a and the first throw node 104a can be in an ON state, and the FET 120b between the pole 102a and the second throw node 104b can be in an OFF state. For the shunt FETs 122a, 122b, the shunt FET 122a can be in an OFF state so that the RF signal is not shunted to ground as it travels from the pole 102a to the first throw node 104a. The shunt FET 122b associated with the second throw node 104b can be in an ON state so that any RF signals or noise arriving at the RF core 110 through the second throw node 104b is shunted to the ground so as to reduce undesirable interference effects to the pole-to-first-throw operation.

Although the foregoing example is described in the context of a single-pole-double-throw configuration, it will be understood that the RF core can be configured with other numbers of poles and throws. For example, there may be more than one poles, and the number of throws can be less than or greater than the example number of two.

In the example of Figure 17, the transistors between the pole 102a and the two throw nodes 104a, 104b are depicted as single transistors. In some implementations, such switching functionalities between the pole(s) and the throw(s) can be provided by switch arm segments, where each switch arm segment includes a plurality of transistors such as FETs.

An example RF core configuration 130 of an RF core having such switch arm segments is shown in Figure 18. In the example, the pole 102a and the first throw node 104a are shown to be coupled via a first switch arm segment 140a. Similarly, the pole 102a and the second throw node 104b are shown to be coupled via a second switch arm segment 140b. The first throw node 104a is shown to be capable of being shunted to an RF ground via a first shunt arm segment 142a. Similarly, the second throw node 104b is shown to be capable of being shunted to the RF ground via a second shunt arm segment 142b.

In an example operation, when the RF core 130 is in a state where an RF signal is being passed between the pole 102a and the first throw node 104a, all of the FETs in the first switch arm segment 140a can be in an ON state, and all of the FETs in the second switch arm segment 104b can be in an OFF state. The first shunt arm 142a for the first throw node 104a can have all of its FETs in an OFF state so that the RF signal is not shunted to ground as it travels from the pole 102a to the first throw node 104a. All of the FETs in the second shunt arm 142b associated with the second throw node 104b can be in an ON state so that any RF signals or noise arriving at the RF core 130 through the second throw node 104b is shunted to the ground so as to reduce undesirable interference effects to the pole-to-first-throw operation.

Again, although described in the context of an SP2T configuration, it will be understood that RF cores having other numbers of poles and throws can also be implemented.

In some implementations, a switch arm segment (e.g., 140a, 140b, 142a, 142b) can include one or more semiconductor transistors such as FETs. In some embodiments, an FET may be capable of being in a first state or a second state and can include a gate, a drain, a source, and a body (sometimes also referred to as a substrate). In some embodiments, an FET can include a metal-oxide-semiconductor field effect transistor (MOSFET). In some embodiments, one or more FETs can be connected in series forming a first end and a second end such that an RF signal can be routed between the first end and the second end when the FETs are in a first state (e.g., ON state).

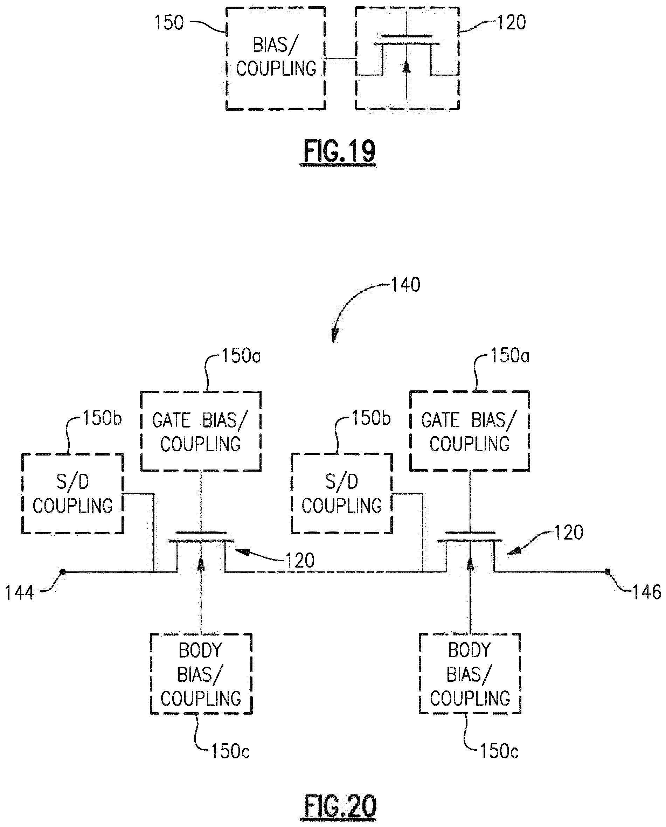

At least some of the present disclosure relates to how a FET or a group of FETs can be controlled to provide switching functionalities in desirable manners. Figure 19 schematically shows that in some implementations, such controlling of an FET 120 can be facilitated by a circuit 150 configured to bias and/or couple one or more portions of the FET 120. In some embodiments, such a circuit 150 can include one or more circuits configured to bias and/or couple a gate of the FET 120, bias and/or couple a body of the FET 120, and/or couple a source/drain of the FET 120.

Schematic examples of how such biasing and/or coupling of different parts of one or more FETs are described in reference to Figure 20. In Figure 20, a switch arm segment 140 (that can be, for example, one of the example switch arm segments 140a, 140b, 142a, 142b of the example of Figure 18) between nodes 144, 146 is shown to include a plurality of FETs 120. Operations of such FETs can be controlled and/or facilitated by a gate bias/coupling circuit 150a, and a body bias/coupling circuit 150c, and/or a source/drain coupling circuit 150b.

### Gate Bias/Coupling Circuit

In the example shown in Figure 20, the gate of each of the FETs 120 can be connected to the gate bias/coupling circuit 150a to receive a gate bias signal and/or couple the gate to another part of the FET 120 or the switch arm 140. In some implementations, designs or features of the gate bias/coupling circuit 150a can improve performance of the switch arm 140. Such improvements in performance can include, but are not limited to, device insertion loss, isolation performance, power handling capability and/or switching device linearity.

### Body Bias/Coupling Circuit

As shown in Figure 20, the body of each FET 120 can be connected to the body bias/coupling circuit 150c to receive a body bias signal and/or couple the body to another part of the FET 120 or the switch arm 140. In some implementations, designs or features of the body bias/coupling circuit 150c can improve performance of the switch arm 140. Such improvements in performance can include, but are not limited to, device insertion loss, isolation performance, power handling capability and/or switching device linearity.

### Source/Drain Coupling Circuit

As shown in Figure 20, the source/drain of each FET 120 can be connected to the coupling circuit 150b to couple the source/drain to another part of the FET 120 or the switch arm 140. In some implementations, designs or features of the coupling circuit 150b can improve performance of the switch arm 140. Such improvements in performance can include, but are not limited to, device insertion loss, isolation performance, power handling capability and/or switching device linearity.

### Examples of Switching Performance Parameters:

### Insertion Loss

A switching device performance parameter can include a measure of insertion loss. A switching device insertion loss can be a measure of the attenuation of an RF signal that is routed through the RF switching device. For example, the magnitude of an RF signal at an output port of a switching device can be less than the magnitude of the RF signal at an input port of the switching device. In some embodiments, a switching device can include device components that introduce parasitic capacitance, inductance, resistance, or conductance into the device, contributing to increased switching device insertion loss. In some embodiments, a switching device insertion loss can be measured as a ratio of the power or voltage of an RF signal at an input port to the power or voltage of the RF signal at an output port of the switching device. Decreased switching device insertion loss can be desirable to enable improved RF signal transmission.

### Isolation

A switching device performance parameter can also include a measure of isolation. Switching device isolation can be a measure of the RF isolation between an input port and an output port an RF switching device. In some embodiments, it can be a measure of the RF isolation of a switching device while the switching device is in a state where an input port and an output port are electrically isolated, for example while the switching device is in an OFF state. Increased switching device isolation can improve RF signal integrity. In certain embodiments, an increase in isolation can improve wireless communication device performance.

### Intermodulation Distortion

A switching device performance parameter can further include a measure of intermodulation distortion (IMD) performance. Intermodulation distortion (IMD) can be a measure of non-linearity in an RF switching device.

IMD can result from two or more signals mixing together and yielding frequencies that are not harmonic frequencies. For example, suppose that two signals have fundamental frequencies f₁ and f₂ (f₂ > f₁) that are relatively close to each other in frequency space. Mixing of such signals can result in peaks in frequency spectrum at frequencies corresponding to different products of fundamental and harmonic frequencies of the two signals. For example, a second-order intermodulation distortion (also referred to as IMD2) is typically considered to include frequencies f₁+f₂ f₂-f₁, 2f₁, and 2f₂. A third-order IMD (also referred to as IMD3) is typically considered to include 2f₁+f₂, 2f₁-f₂, f₁+2f₂, f₁-2f₂. Higher order products can be formed in similar manners.

In general, as the IMD order number increases, power levels decrease. Accordingly, second and third orders can be undesirable effects that are of particular interest. Higher orders such as fourth and fifth orders can also be of interest in some situations.

In some RF applications, it can be desirable to reduce susceptibility to interference within an RF system. Non linearity in RF systems can result in introduction of spurious signals into the system. Spurious signals in the RF system can result in interference within the system and degrade the information transmitted by RF signals. An RF system having increased non-linearity can demonstrate increased susceptibility to interference. Non-linearity in system components, for example switching devices, can contribute to the introduction of spurious signals into the RF system, thereby contributing to degradation of overall RF system linearity and IMD performance.

In some embodiments, RF switching devices can be implemented as part of an RF system including a wireless communication system. IMD performance of the system can be improved by increasing linearity of system components, such as linearity of an RF switching device. In some embodiments, a wireless communication system can operate in a multi-band and/or multi-mode environment. Improvement in intermodulation distortion (IMD) performance can be desirable in wireless communication systems operating in a multi-band and/or multi-mode environment. In some embodiments, improvement of a switching device IMD performance can improve the IMD performance of a wireless communication system operating in a multi-mode and/or multi-band environment.

Improved switching device IMD performance can be desirable for wireless communication devices operating in various wireless communication standards, for example for wireless communication devices operating in the LTE communication standard. In some RF applications, it can be desirable to improve linearity of switching devices operating in wireless communication devices that enable simultaneous transmission of data and voice communication. For example, improved IMD performance in switching devices can be desirable for wireless communication devices operating in the LTE communication standard and performing simultaneous transmission of voice and data communication (e.g., SVLTE).

### High Power Handling Capability

In some RF applications, it can be desirable for RF switching devices to operate under high power while reducing degradation of other device performance parameters. In some embodiments, it can be desirable for RF switching devices to operate under high power with improved intermodulation distortion, insertion loss, and/or isolation performance.

In some embodiments, an increased number of transistors can be implemented in a switch arm segment of a switching device to enable improved power handling capability of the switching device. For example, a switch arm segment can include an increased number of FETs connected in series, an increased FET stack height, to enable improved device performance under high power. However, in some embodiments, increased FET stack height can degrade the switching device insertion loss performance.

### Examples of FET Structures and Fabrication Process Technologies:

A switching device can be implemented on-die, off-die, or some combination thereof. A switching device can also be fabricated using various technologies. In some embodiments, RF switching devices can be fabricated with silicon or silicon-on-insulator (SOI) technology.

As described herein, an RF switching device can be implemented using silicon-on-insulator (SOI) technology. In some embodiments, SOI technology can include a semiconductor substrate having an embedded layer of electrically insulating material, such as a buried oxide layer beneath a silicon device layer. For example, an SOI substrate can include an oxide layer embedded below a silicon layer. Other insulating materials known in the art can also be used.

Implementation of RF applications, such as an RF switching device, using SOI technology can improve switching device performance. In some embodiments, SOI technology can enable reduced power consumption. Reduced power consumption can be desirable in RF applications, including those associated with wireless communication devices. SOI technology can enable reduced power consumption of device circuitry due to decreased parasitic capacitance of transistors and interconnect metallization to a silicon substrate. Presence of a buried oxide layer can also reduce junction capacitance or use of high resistivity substrate, enabling reduced substrate related RF losses. Electrically isolated SOI transistors can facilitate stacking, contributing to decreased chip size.

In some SOI FET configurations, each transistor can be configured as a finger-based device where the source and drain are rectangular shaped (in a plan view) and a gate structure extends between the source and drain like a rectangular shaped finger. Figures 21A and 21B show plan and side sectional views of an example finger-based FET device implemented on SOI. As shown, FET devices described herein can include a p-type FET or an n-type FET. Thus, although some FET devices are described herein as p-type devices, it will be understood that various concepts associated with such p-type devices can also apply to n-type devices.

As shown in Figures 21A and 21B, a pMOSFET can include an insulator layer formed on a semiconductor substrate. The insulator layer can be formed from materials such as silicon dioxide or sapphire. An n-well is shown to be formed in the insulator such that the exposed surface generally defines a rectangular region. Source (S) and drain (D) are shown to be p-doped regions whose exposed surfaces generally define rectangles. As shown, S/D regions can be configured so that source and drain functionalities are reversed.

Figures 21A and 21B further show that a gate (G) can be formed on the n-well so as to be positioned between the source and the drain. The example gate is depicted as having a rectangular shape that extends along with the source and the drain. Also shown is an n-type body contact. Formations of the rectangular shaped well, source and drain regions, and the body contact can be achieved by a number of known techniques.

Figures 22A and 22B show plan and side sectional views of an example of a multiple-finger FET device implemented on SOI. Formations of rectangular shaped n-well, rectangular shaped p-doped regions, rectangular shaped gates, and n-type body contact can be achieved in manners similar to those described in reference to Figures 21A and 21B.

The example multiple-finger FET device of Figures 22A and 22B can be configured so that the source regions are electrically connected together to a source node, and the drain regions are connected together to a drain node. The gates can also be connected together to a gate node. In such an example configuration, a common gate bias signal can be provided through the gate node to control flow of current between the source node and the drain node.

In some implementations, a plurality of the foregoing multi-finger FET devices can be connected in series as a switch to allow handling of high power RF signals. Each FET device can divide the overall voltage drop associated with power dissipation at the connected FETs. A number of such multi-finger FET devices can be selected based on, for example, power handling requirement of the switch.

### Examples of Implementations in Products:

Various examples of FET-based switch circuits described herein can be implemented in a number of different ways and at different product levels. Some of such product implementations are described by way of examples.

### Semiconductor Die Implementation

Figures 23A-23D show non-limiting examples of such implementations on one or more semiconductor die. Figure 23A shows that in some embodiments, a switch circuit 120 and a bias/coupling circuit 150 having one or more features as described herein can be implemented on a die 800. Figure 23B shows that in some embodiments, at least some of the bias/coupling circuit 150 can be implemented outside of the die 800 of Figure 23A. Figure 23C shows that in some embodiments, a switch circuit 120 having one or more features as described herein can be implemented on a first die 800a, and a bias/coupling circuit 150 having one or more features as described herein can be implemented on a second die 800b. Figure 23D shows that in some embodiments, at least some of the bias/coupling circuit 150 can be implemented outside of the first die 800a of Figure 23C.

### Packaged Module Implementation

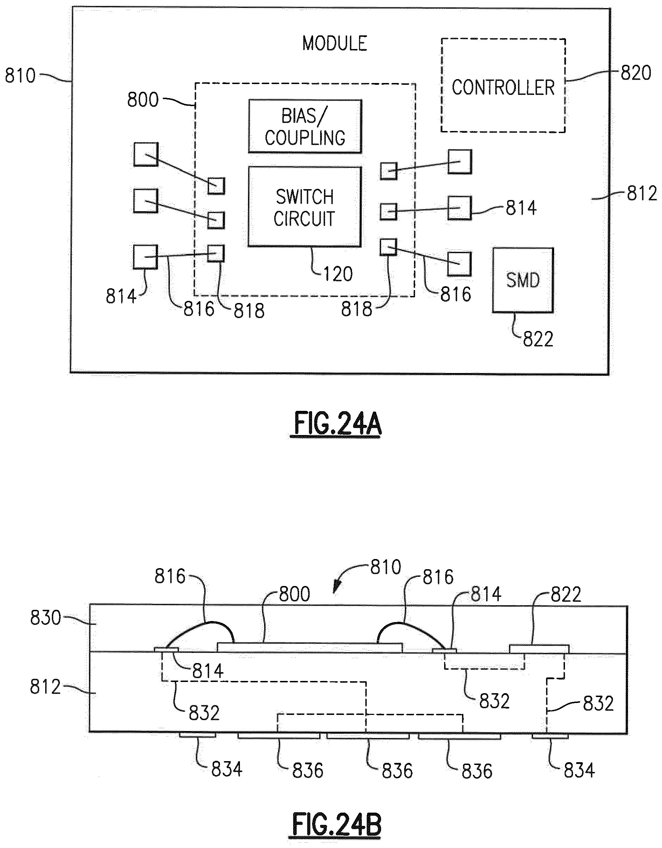

In some embodiments, one or more die having one or more features described herein can be implemented in a packaged module. An example of such a module is shown in Figures 24A (plan view) and 24B (side view). Although described in the context of both of the switch circuit and the bias/coupling circuit being on the same die (e.g., example configuration of Figure 23A), it will be understood that packaged modules can be based on other configurations.

A module 810 is shown to include a packaging substrate 812. Such a packaging substrate can be configured to receive a plurality of components, and can include, for example, a laminate substrate. The components mounted on the packaging substrate 812 can include one or more dies. In the example shown, a die 800 having a switching circuit 120 and a bias/coupling circuit 150 is shown to be mounted on the packaging substrate 812. The die 800 can be electrically connected to other parts of the module (and with each other where more than one die is utilized) through connections such as connection-wirebonds 816. Such connection-wirebonds can be formed between contact pads 818 formed on the die 800 and contact pads 814 formed on the packaging substrate 812. In some embodiments, one or more surface mounted devices (SMDs) 822 can be mounted on the packaging substrate 812 to facilitate various functionalities of the module 810.

In some embodiments, the packaging substrate 812 can include electrical connection paths for interconnecting the various components with each other and/or with contact pads for external connections. For example, a connection path 832 is depicted as interconnecting the example SMD 822 and the die 800. In another example, a connection path 832 is depicted as interconnecting the SMD 822 with an external-connection contact pad 834. In yet another example a connection path 832 is depicted as interconnecting the die 800 with ground-connection contact pads 836.

In some embodiments, a space above the packaging substrate 812 and the various components mounted thereon can be filled with an overmold structure 830. Such an overmold structure can provide a number of desirable functionalities, including protection for the components and wirebonds from external elements, and easier handling of the packaged module 810.

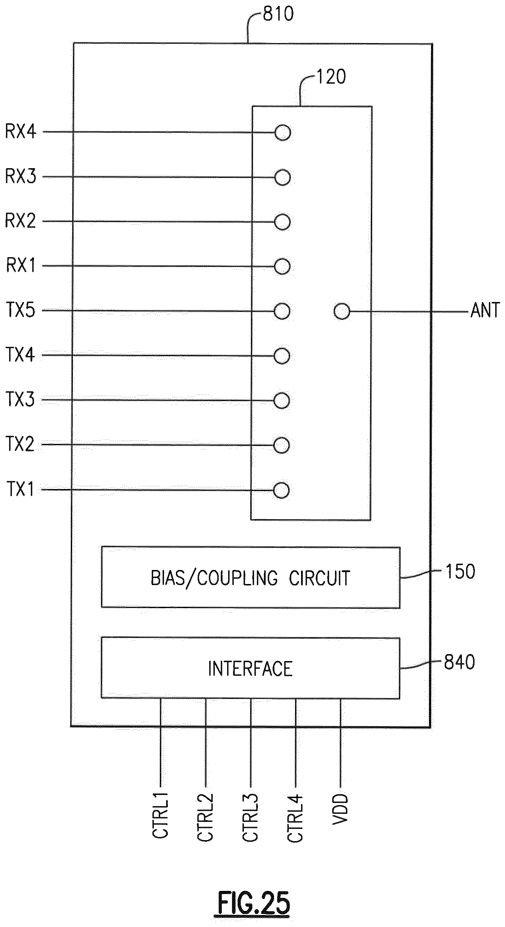

Figure 25 shows a schematic diagram of an example switching configuration that can be implemented in the module 810 described in reference to Figures 24A and 24B. In the example, the switch circuit 120 is depicted as being an SP9T switch, with the pole being connectable to an antenna and the throws being connectable to various Rx and Tx paths. Such a configuration can facilitate, for example, multi-mode multi-band operations in wireless devices.

The module 810 can further include an interface for receiving power (e.g., supply voltage VDD) and control signals to facilitate operation of the switch circuit 120 and/or the bias/coupling circuit 150. In some implementations, supply voltage and control signals can be applied to the switch circuit 120 via the bias/coupling circuit 150.

### Wireless Device Implementation

In some implementations, a device and/or a circuit having one or more features described herein can be included in an RF device such as a wireless device. Such a device and/or a circuit can be implemented directly in the wireless device, in a modular form as described herein, or in some combination thereof. In some embodiments, such a wireless device can include, for example, a cellular phone, a smart-phone, a hand-held wireless device with or without phone functionality, a wireless tablet, etc.

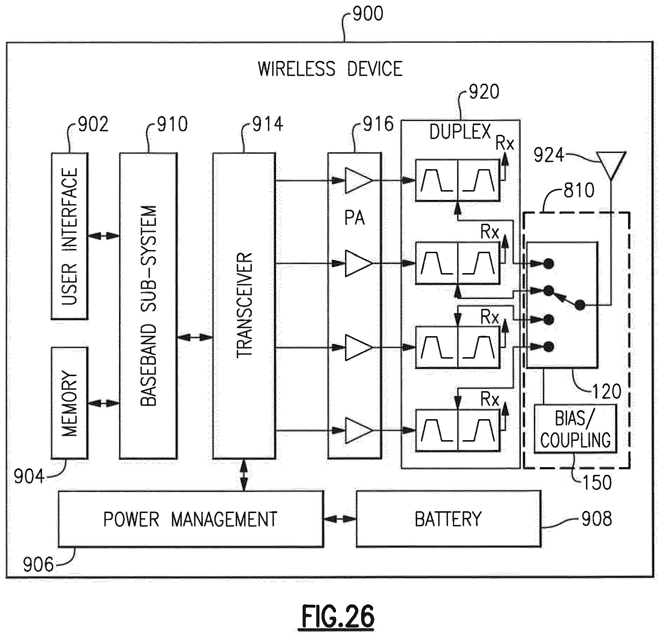

Figure 26 schematically depicts an example wireless device 900 having one or more advantageous features described herein. In the context of various switches and various biasing/coupling configurations as described herein, a switch 120 and a bias/coupling circuit 150 can be part of a module 810. In some embodiments, such a switch module can facilitate, for example, multi-band multi-mode operation of the wireless device 900.

In the example wireless device 900, a power amplifier (PA) module 916 having a plurality of PAs can provide an amplified RF signal to the switch 120 (via a duplexer 920), and the switch 120 can route the amplified RF signal to an antenna. The PA module 916 can receive an unamplified RF signal from a transceiver 914 that can be configured and operated in known manners. The transceiver can also be configured to process received signals. The transceiver 914 is shown to interact with a baseband sub-system 910 that is configured to provide conversion between data and/or voice signals suitable for a user and RF signals suitable for the transceiver 914. The transceiver 914 is also shown to be connected to a power management component 906 that is configured to manage power for the operation of the wireless device 900. Such a power management component can also control operations of the baseband sub-system 910 and the module 810.

The baseband sub-system 910 is shown to be connected to a user interface 902 to facilitate various input and output of voice and/or data provided to and received from the user. The baseband sub-system 910 can also be connected to a memory 904 that is configured to store data and/or instructions to facilitate the operation of the wireless device, and/or to provide storage of information for the user.

In some embodiments, the duplexer 920 can allow transmit and receive operations to be performed simultaneously using a common antenna (e.g., 924). In Figure 26, received signals are shown to be routed to "Rx" paths (not shown) that can include, for example, a low-noise amplifier (LNA).

A number of other wireless device configurations can utilize one or more features described herein. For example, a wireless device does not need to be a multi-band device. In another example, a wireless device can include additional antennas such as diversity antenna, and additional connectivity features such as Wi-Fi, Bluetooth, and GPS.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." The word "coupled", as generally used herein, refers to two or more elements that may be either directly connected, or connected by way of one or more intermediate elements. Additionally, the words "herein," "above," "below," and words of similar import, when used in this application, shall refer to this application as a whole and not to any particular portions of this application. Where the context permits, words in the above Detailed Description using the singular or plural number may also include the plural or singular number respectively. The word "or" in reference to a list of two or more items, that word covers all of the following interpretations of the word: any of the items in the list, all of the items in the list, and any combination of the items in the list.

The above detailed description of embodiments of the invention is not intended to be exhaustive or to limit the invention to the precise form disclosed above. While specific embodiments of, and examples for, the invention are described above for illustrative purposes, various equivalent modifications are possible within the scope of the invention, as those skilled in the relevant art will recognize. For example, while processes or blocks are presented in a given order, alternative embodiments may perform routines having steps, or employ systems having blocks, in a different order, and some processes or blocks may be deleted, moved, added, subdivided, combined, and/or modified. Each of these processes or blocks may be implemented in a variety of different ways. Also, while processes or blocks are at times shown as being performed in series, these processes or blocks may instead be performed in parallel, or may be performed at different times.

The teachings of the invention provided herein can be applied to other systems, not necessarily the system described above. The elements and acts of the various embodiments described above can be combined to provide further embodiments.

## Claims

1. A switching device (100) comprising:
a first terminal and a second terminal; and
a plurality of field-effect transistors (FETs) (300) connected in series to form a stack (200) between the first terminal and the second terminal, the field-effect transistors (FETs) having a source (326), a drain (328) and a gate (304) formed on an active region (302) and having a tuned non-uniform distribution (330) of gate lengths of field-effect transistors based on a scaled-up non-uniform distribution of drain-to-source voltage (VDS) across each field-effect transistor corresponding to a similar stack having a uniform distribution of the gate lengths, the tuned non-uniform distribution (330) resulting in the stack (200) having one or more of a first voltage handling capacity that is greater than a second voltage handling capacity corresponding to the similar stack, a first ON-resistance (Ron) value that is less than a second ON-resistance (Ron) value corresponding to the similar stack, and a first linearity performance that is better than a second linearity performance corresponding to the similar stack, the tuned non-uniform distribution (330) including at least some gate lengths that are greater than a value of the uniform distribution of the gate length, and having at least some gate lengths that are less than the value of the uniform distribution of the gate length.

2. The switching device of claim 1 wherein the field-effect transistor (FET) is implemented as a silicon-on-insulator (SOI) device.

3. The switching device of claim 1 wherein the sum of the drain-to-source voltage VDS values of the field-effect transistors (FETs) for the tuned non-uniform distribution of the gate length is greater than the sum of the drain-to-source voltage VDS values of the field-effect transistors (FETs) for the uniform distribution of the gate length.

4. The switching device of claim 3 wherein the sum of the gate lengths of the field-effect transistor (FETs) for the tuned non-uniform distribution of the gate length is greater than the sum of the gate length of the field-effect transistor (FETs) for the uniform distribution of the gate length.

5. The switching device of claim 1 wherein the tuned non-uniform distribution of the gate length includes a plurality of groups of gate length values, each group having a common value of the gate length.

6. A semiconductor die (800) comprising:
a semiconductor substrate; and
the switching device of any of claims 1 to 5 implemented on the semiconductor substrate.

7. A radio-frequency (RF) switching module (810) comprising:
a packaging substrate (812) configured to receive a plurality of components; and the semiconductor die of claim 6 mounted on the packaging substrate (812).

8. A wireless device (900) comprising:
a transmitter (914);
a power amplifier (916) in communication with the transmitter (914), the power amplifier configured to amplify a radio-frequency (RF) signal generated by the transmitter;
an antenna (924) configured to transmit the amplified radio-frequency (RF) signal; and
the RF switching module of claim 7 configured to route the amplified radio-frequency (RF) signal from the power amplifier to the antenna.

9. A method for fabricating a radio-frequency (RF) switching device, the method comprising:
providing a semiconductor substrate (371);
forming a plurality of field-effect transistors (FETs) having a source, a drain and a gate formed on an active region on the semiconductor substrate such that the field-effect transistors (FETs) have a tuned non-uniform distribution of gate lengths of field-effect transistors based on a scaled-up non-uniform distribution of drain-to-source voltage (VDS) across each field-effect transistor (372) corresponding to a similar stack having a uniform distribution of the gate lengths; and
connecting the field-effect transistors (FETs) to form a stack, such that the tuned non-uniform distribution results in the stack having one or more of a first voltage handling capacity that is greater than a second voltage handling capacity corresponding to the similar stack, a first ON-resistance (Ron) value that is less than a second ON-resistance (Ron) value corresponding to the similar stack, and a first linearity performance that is better than a second linearity performance corresponding to the similar stack, the tuned non-uniform distribution (330) including at least some gate lengths that are greater than a value of the uniform distribution of the gate length, and having at least some gate lengths that are less than the value of the uniform distribution of the gate length.

## Patentansprüche

1. Schaltvorrichtung (100), umfassend:
einen ersten Anschluss und einen zweiten Anschluss; und
mehrere Feldeffekttransistoren (FETs) (300), die in Reihe geschaltet sind, um einen Stapel (200) zwischen dem ersten Anschluss und dem zweiten Anschluss zu bilden, wobei die Feldeffekttransistoren (FETs) eine Quelle (326), eine Senke (328) und ein Gatter (304) aufweisen, die auf einem aktiven Bereich (302) ausgebildet sind, und eine abgestimmte, ungleichmäßige Verteilung (330) von Gatterlängen von Feldeffekttransistoren basierend auf einer hochskalierten, ungleichmäßigen Verteilung der Senken-Quellen-Spannung (VDS) durch jeden Feldeffekttransistor entsprechend einem ähnlichen Stapel mit einer gleichmäßigen Verteilung der Gatterlängen aufweisen, wobei die abgestimmte, ungleichmäßige Verteilung (330) dazu führt, dass der Stapel (200) eins oder mehr aufweist von einer ersten Spannungsverarbeitungskapazität, die größer als eine zweite Spannungsverarbeitungskapazität entsprechend dem ähnlichen Stapel ist, einem ersten EIN-Widerstandswert (Ron), der kleiner als ein zweiter EIN-Widerstandswert (Ron) entsprechend dem ähnlichen Stapel ist, und einer ersten Linearitätsleistung, die besser als eine zweite Linearitätsleistung entsprechend dem ähnlichen Stapel ist, wobei die abgestimmte, ungleichmäßige Verteilung (330) zumindest einige Gatterlängen enthält, die größer als ein Wert der gleichmäßigen Verteilung der Gatterlänge sind, und zumindest einige Gatterlängen aufweist, die kleiner als der Wert der gleichmäßigen Verteilung der Gatterlänge sind.

2. Schaltvorrichtung nach Anspruch 1, wobei der Feldeffekttransistor (FET) als eine Silicon-On-Insulator-Vorrichtung (SOI-Vorrichtung) implementiert ist.

3. Schaltvorrichtung nach Anspruch 1, wobei die Summe der Senke-Quellen-Spannungswerte VDS der Feldeffekttransistoren (FETs) für die abgestimmte, ungleichmäßige Verteilung der Gatterlänge größer als die Summe der Senke-Quellen-Spannungswerte VDS der Feldeffekttransistoren (FETs) für die gleichmäßige Verteilung der Gatterlänge ist.

4. Schaltvorrichtung nach Anspruch 3, wobei die Summe der Gatterlängen der Feldeffekttransistoren (FETs) für die abgestimmte, ungleichmäßige Verteilung der Gatterlänge größer als die Summe der Gatterlänge der Feldeffekttransistoren (FETs) für die gleichmäßige Verteilung der Gatterlänge ist.

5. Schaltvorrichtung nach Anspruch 1, wobei die abgestimmte, ungleichmäßige Verteilung der Gatterlänge mehrere Gruppen von Gatterlängenwerten enthält, wobei jede Gruppe einen gemeinsamen Wert der Gatterlänge aufweist.

6. Halbleiterchip (800), umfassend:
ein Halbleitersubstrat; und
die Schaltvorrichtung nach einem der Ansprüche 1 bis 5, die auf dem Halbleitersubstrat implementiert ist.

7. Hochfrequenz-(HF)-Schaltmodul (810), umfassend:
ein Paketsubstrat (812), das dafür ausgelegt ist, mehrere Komponenten aufzunehmen; und
den Halbleiterchip nach Anspruch 6, der auf dem Paketsubstrat (812) montiert ist.

8. Drahtlose Vorrichtung (900), umfassend:
einen Sender (914);
einen Leistungsverstärker (916) in Kommunikation mit dem Sender (914), wobei der Leistungsverstärker dafür ausgelegt ist, ein vom Sender erzeugtes Hochfrequenz-(HF)-Signal zu verstärken;
eine Antenne (924), die dafür ausgelegt ist, das verstärkte Hochfrequenz-(HF)-Signal zu übertragen; und
das HF-Schaltmodul nach Anspruch 7, das dafür ausgelegt ist, das verstärkte Hochfrequenz-(HF)-Signal vom Leistungsverstärker zur Antenne zu führen.

9. Verfahren zur Herstellung einer Hochfrequenz-(HF)-Schaltvorrichtung, wobei das Verfahren umfasst:
Bereitstellen eines Halbleitersubstrats (371);
Bilden von mehreren Feldeffekttransistoren (FETs), die eine Quelle, eine Senke und ein Gatter aufweisen, die derart auf einem aktiven Bereich auf dem Halbleitersubstrat ausgebildet sind, dass die Feldeffekttransistoren (FETs) eine abgestimmte, ungleichmäßige Verteilung von Gatterlängen von Feldeffekttransistoren basierend auf einer hochskalierten, ungleichmäßigen Verteilung der Senken-Quellen-Spannung (VDS) durch jeden Feldeffekttransistor (372) entsprechend einem ähnlichen Stapel mit einer gleichmäßigen Verteilung der Gatterlängen aufweisen, und
Verbinden der Feldeffekttransistoren (FETs), um einen Stapel derart zu bilden, dass die abgestimmte, ungleichmäßige Verteilung dazu führt, dass der Stapel eines oder mehrere aufweist von einer ersten Spannungsverarbeitungskapazität, die größer als eine zweite Spannungsverarbeitungskapazität entsprechend dem ähnlichen Stapel ist, einem ersten EIN-Widerstandswert (Ron), der kleiner als ein zweiter ElN-Widerstandswert (Ron) entsprechend dem ähnlichen Stapel ist, und einer ersten Linearitätsleistung, die besser als eine zweite Linearitätsleistung entsprechend dem ähnlichen Stapel ist, wobei die abgestimmte, ungleichmäßige Verteilung (330) zumindest einige Gatterlängen enthält, die größer als ein Wert der gleichmäßigen Verteilung der Gatterlänge sind, und zumindest einige Gatterlängen aufweist, die kleiner als der Wert der gleichmäßigen Verteilung der Gatterlänge sind.

## Revendications

1. Dispositif de commutation (100) comprenant :
un premier terminal et un second terminal ; et
une pluralité de transistors à effet de champ (FET) (300) reliés en série pour former une pile (200) entre le premier terminal et le second terminal, les transistors à effet de champ (FET) ayant une source (326), un drain (328) et une grille (304) formés sur une zone active (302) et ayant une distribution non uniforme ajustée (330) de longueurs de grille de transistors à effet de champ sur la base d'une distribution non uniforme à grande échelle de tension drain-source (VDS) à travers chaque transistor à effet de champ correspondant à une pile similaire ayant une distribution uniforme des longueurs de grille,
la distribution non uniforme ajustée (330) amenant la pile (200) à avoir une ou plusieurs parmi une première capacité de gestion de tension qui est supérieure à une seconde capacité de gestion de tension correspondant à la pile similaire, une première valeur de résistance à l'état passant (Ron) qui est inférieure à une seconde valeur de résistance à l'état passant correspondant à la pile similaire, et une première performance de linéarité qui est meilleure qu'une seconde performance de linéarité correspondant à la pile similaire, la distribution non uniforme ajustée (330) incluant au moins certaines longueurs de grille qui sont supérieures à une valeur de la distribution uniforme de la longueur de grille, et ayant au moins certaines longueurs de grille qui sont inférieures à la valeur de la distribution uniforme de la longueur de grille.

2. Dispositif de commutation selon la revendication 1, dans lequel le transistor à effet de champ (FET) est mis en oeuvre en tant que dispositif à silicium sur isolant (SOI).

3. Dispositif de commutation selon la revendication 1, dans lequel la somme des valeurs de tension drain-source VDS des transistors à effet de champ (FET) pour la distribution non uniforme ajustée de la longueur de grille est supérieure à la somme des valeurs de tension drain-source VDS des transistors à effet de champ (FET) pour la distribution uniforme de la longueur de grille.

4. Dispositif de commutation selon la revendication 3, dans lequel la somme des longueurs de grille des transistors à effet de champ (FET) pour la distribution non uniforme ajustée de la longueur de grille est supérieure à la somme de la longueur de grille des transistors à effet de champ (FET) pour la distribution uniforme de la longueur de grille.

5. Dispositif de commutation selon la revendication 1, dans lequel la distribution non uniforme ajustée de la longueur de grille inclut une pluralité de groupes de valeurs de longueur de grille, chaque groupe ayant une valeur commune de la longueur de grille.

6. Puce semiconductrice (800) comprenant :
un substrat semiconducteur ; et
le dispositif de commutation selon l'une quelconque des revendications 1 à 5 mis en oeuvre sur le substrat semiconducteur.

7. Module de commutation de radiofréquence (RF) (810) comprenant :
un substrat d'emballage (812) configuré pour recevoir une pluralité de composants ; et
la puce semiconductrice selon la revendication 6 montée sur le substrat d'emballage (812).

8. Dispositif sans fil (900) comprenant :
un émetteur (914) ;
un amplificateur de puissance (916) en communication avec l'émetteur (914), l'amplificateur de puissance étant configuré pour amplifier un signal radiofréquence (RF) généré par l'émetteur ;
une antenne (924) configurée pour émettre le signal radiofréquence amplifié (RF) ; et
le module de commutation RF selon la revendication 7 configuré pour acheminer le signal radiofréquence amplifié (RTF) de l'amplificateur de puissance à l'antenne.

9. Procédé de fabrication d'un dispositif de commutation de radiofréquence (RF), le procédé comprenant :
la fourniture d'un substrat semiconducteur (371) ;
la formation d'une pluralité de transistors à effet de champ (FET) ayant une source, un drain et une grille formés sur une zone active du substrat semiconducteur de sorte que les transistors à effet de champ (FET) ont une distribution non uniforme ajustée de longueurs de grille de transistors à effet de champ sur la base d'une distribution non uniforme à grande échelle de tension drain-source (VDS) à travers chaque transistor à effet de champ (372) correspondant à une pile similaire ayant une distribution uniforme des longueurs de grille ; et
la liaison des transistors à effet de champ (FET) pour former une pile, de sorte que la distribution non uniforme ajustée amène la pile à avoir une ou plusieurs parmi une première capacité de gestion de tension qui est supérieure à une seconde capacité de gestion de tension correspondant à la pile similaire, une première valeur de résistance à l'état passant (Ron) qui est inférieure à une seconde valeur de résistance à l'état passant (Ron) correspondant à la pile similaire, et une première performance de linéarité qui est meilleure qu'une seconde performance de linéarité correspondant à la pile similaire, la distribution non uniforme ajustée (330) incluant au moins certaines longueurs de grille qui sont supérieures à une valeur de la distribution uniforme de la longueur de grille, et ayant au moins certaines longueurs de grille qui sont inférieures à la valeur de la distribution uniforme de la longueur de grille.
